# EUROPÄISCHE PATENTSCHRIFT

(11) **EP 3 251 215 B1**
(45) Veröffentlichungstag und Bekanntmachung des Hinweises auf die Patenterteilung: **21.04.2021**
(21) Anmeldenummer: 16701586.6
(22) Anmeldetag: 21.01.2016
(51) Int. Cl.: H03K 19/0175, H03K 19/0185, H03K 19/0944, B60R 16/023, H04L 12/40

(54) **STEUERVORRICHTUNG FÜR EIN MEHRSPANNUNGSBORDNETZ**
CONTROLLER FOR A MULTI-VOLTAGE ON-BOARD POWER SUPPLY
DISPOSITIF DE COMMANDE DESTINÉ À UN RÉSEAU DE BORD À TENSIONS MULTIPLES

(30) Priorität: 29.01.2015 DE 102015201572
(43) Veröffentlichungstag der Anmeldung: 06.12.2017
(73) Patentinhaber: Brose Fahrzeugteile SE & Co. Kommanditgesellschaft, Bamberg, 96052 Bamberg (DE)
(72) Erfinder: DREMEL, Benedikt, 96135 Stegaurach (DE); MIJAC, Anto, 97475 Zeil am Main (DE)
(74) Vertreter: Maikowski & Ninnemann Patentanwälte Partnerschaft mbB
(86) Internationale Anmeldenummer: PCT/EP2016/051181
(87) Internationale Veröffentlichungsnummer: WO 2016/120142

(56) Entgegenhaltungen:
- EP-A1- 1 743 820
- WO-A1-2015/014552
- US-A- 5 646 552
- US-A1- 2004 130 379

## Beschreibung

Die vorliegende Erfindung betrifft eine Steuervorrichtung für ein Mehrspannungsbordnetz eines Fahrzeugs.

Gelegentlich wird ein Fahrzeug, beispielsweise ein PKW, LKW, ein Zug etc., mit einem Mehrspannungsnetz ausgestattet. Das Mehrspannungsbordnetz umfasst wenigstens ein erstes Teilnetz und ein zweites Teilnetz. Das erste Teilnetz ist ausgebildet, von einer ersten Spannungsversorgungsquelle mit einer ersten Versorgungsspannung, beispielsweise 12 V, betrieben zu werden. Das zweite Teilnetz ist ausgebildet, von einer zweiten Spannungsversorgungsquelle mit einer zweiten Versorgungsspannung, beispielsweise 48 V, betrieben zu werden.

In einem derartigen Mehrspannungsbordnetz kommt gelegentlich eine Steuervorrichtung zum Einsatz, die sowohl an das erste Teilnetz als auch an das zweite Teilnetz gekoppelt sein kann. Innerhalb der Steuervorrichtung können folglich beide Spannungsebenen der beiden Teilnetze präsent sein.

Beispielsweise umfasst eine derartige Steuervorrichtung einen Sendeempfänger, der über einen ersten Masseanschluss auf Masse, beispielsweise Fahrzeugmasse, geschaltet ist und der ausgebildet ist zum Kommunizieren mit einer Kommunikationskomponente des ersten Teilnetzes. Beispielsweise umfasst ein solcher Sendeempfänger einen sogenannten Local-Interconnect-Network- (LIN-) Transceiver. Außerdem kann eine derartige Steuervorrichtung eine Steuereinheit umfassen, die über einen zweiten Masseanschluss des zweiten Teilnetzte auf Masse, beispielsweise Fahrzeugmasse, geschaltet ist und die ausgebildet ist zum Steuern einer Leistungskomponente des zweiten Teilnetzes.

Der Sendeempfänger ist üblicherweise an die Steuereinheit gekoppelt. Beispielsweise ist für diese Zwecke eine Anzahl von Steuersignalpfaden vorgesehen. Ein Sendepfad koppelt beispielsweise einen Signalausgang der Steuereinheit an einen Signaleingang des Sendeempfängers und in umgekehrter Richtung kann ein Empfangspfad einen Signalausgang des Sendeempfängers an einen Signaleingang der Steuereinheit koppeln. Problematisch bei einer derartigen Steuervorrichtung ist die saubere Trennung zwischen den beiden Teilnetzen, insbesondere im Falle einer fehlerhaften Betriebsspannungsversorgung in dem ersten Teilnetz und/oder in dem zweiten Teilnetz. Die US 5,646,552 beschreibt im Zusammenhang des sog. Small Computer System Interface (SCSI) Standards ein Abschneiden eines Signalpfads zwischen einer Vorrichtung und einer Systemschnittstelle. Das Abschneiden erfolgt, falls ein von der Vorrichtung bereitgestelltes Signal, welches über den die Systemschnittstelle enthaltenen Signalpfad an eine weitere Vorrichtung zu übertragen ist, einen vorbestimmten Pegel aufweist.

Aufgabe der vorliegenden Erfindung ist es, die Kopplung zwischen dem Sendeempfänger und der Steuereinheit der Steuervorrichtung derart zu gestalten, dass ein Steuersignal in sicherer Weise zwischen dem Sendeempfänger und der Steuereinheit übertragen werden kann Die Erfindung ist durch die unabhängigen Ansprüche 1 und 5 definiert.

Gemäß einem ersten Aspekt wird die Steuervorrichtung des unabhängigen Patentanspruchs 1 vorgeschlagen. Einen zweiten Aspekt bildet die Steuervorrichtung des unabhängigen Patentanspruchs 5.

Merkmale vorteilhafter Ausführungsformen sind in den Unteransprüchen angegeben. Die durch die Unteransprüche definierten Merkmale können miteinander zur Bildung weiterer Ausführungsbeispiele kombiniert werden, sofern sie nicht ausdrücklich als alternativ zueinander beschrieben werden.

Bei der Steuervorrichtung des ersten Aspektes koppelt ein Sendepfad einen Signalausgang der Steuereinheit an einen Signaleingang des Sendeempfängers. Der Sendepfad ist ausgebildet zum Übertragen eines von der Steuereinheit am Signalausgang bereitgestellten Steuersignals hin zum Signaleingang des Sendeempfängers. Im Sendepfad ist eine Diode angeordnet, deren Kathodenanschluss an den zweiten Masseanschluss gekoppelt ist. Ferner ist vorgesehen, eine Anzahl von Feldeffekttransistoren, wobei die Anzahl von Feldeffekttransistoren den Sendepfad einerseits an die erste Spannungsversorgungsquelle koppelt und andererseits an den ersten Masseanschluss und/oder an den zweiten Masseanschluss koppelt. Beispielsweise ist die im Sendepfad angeordnete Diode über einen der Anzahl von Feldeffekttransistoren an den zweiten Masseanschluss gekoppelt.

Bei der Steuervorrichtung des zweiten Aspektes koppelt ein Empfangspfad einen Signalausgang des Sendeempfängers an einen Signaleingang der Steuereinheit. Der Empfangspfad ist ausgebildet zum Übertragen eines von dem Sendeempfänger am Signalausgang bereitgestellten Steuersignals hin zum Signaleingang der Steuereinheit. Im Empfangspfad ist eine Diode angeordnet, deren Kathodenanschluss an den zweiten Masseanschluss gekoppelt ist. Ferner ist bei der Steuervorrichtung des zweiten Aspektes eine Anzahl von Transistoren vorgesehen, wobei die Anzahl von Transistoren den Empfangspfad einerseits an die erste Spannungsversorgungsquelle und/oder an die zweite Spannungsversorgungsquelle koppelt und andererseits an den zweiten Masseanschluss. Beispielsweise ist die im Empfangspfad angeordnete Diode über eine Anzahl von Transistoren an den zweiten Masseanschluss gekoppelt.

Die beiden oben dargestellten Aspekte können miteinander kobiniert werden. Bei einer Ausführungsform der Steuervorrichtung sind also der Sendeempfänger und die Steuereinheit über besagten Empfangspfad und über besagten Sendepfad aneinander gekoppelt.

Bei einer Ausführungsform der Steuervorrichtung des ersten Aspektes ist die im Sendepfad angeordnete Diode ausgebildet, einen Fluss eines Stromes von dem ersten Teilnetz in das zweite Teilnetz über den Sendepfad zu sperren. Insoweit kann die im Sendepfad angeordnete Diode eine Trennung der beiden Teilnetze schaffen.

Bei einer Ausführungsform der Steuervorrichtung des zweiten Aspektes ist die im Empfangspfad angeordnete Diode ausgebildet, einen Fluss eines Stromes vom zweiten Teilnetz in das erste Teilnetz über den Empfangspfad zu sperren. Insoweit kann die im Empfangspfad angeordnete Diode eine Trennung der beiden Teilnetze schaffen.

Bei einer weiteren Ausführungsform der Steuervorrichtung des ersten Aspektes ist die Anzahl der Feldeffekttransistoren ausgebildet, in Abhängigkeit eines Zustands des Signalausgangs der Steuereinheit einen Signalpegel im Sendepfad zu produzieren. Beispielsweise ist der Signalausgang der Steuereinheit ein Anschluss, den die Steuereinheit wahlweise in einen der Zustände "LOW", "HIGH" oder "HZ" (hochohmig) setzen kann. Je nachdem, welchen Zustand der Signalausgang der Steuereinheit aufweist, kann die Anzahl der Feldeffekttransistoren in dem Sendepfad einen entsprechenden Signalpegel produzieren. Der Sendeempfänger, dessen Signaleingang an den Sendepfad gekoppelt ist, kann das von der Steuereinheit bereitgestellte Steuersignal mit dem von der Anzahl der Feldeffekttransistoren produzierten Signalpegel empfangen.

Bei einer weiteren Ausführungsform der Steuervorrichtung des zweiten Aspektes ist die Anzahl der Transistoren ausgebildet, in Abhängigkeit von einem Zustand des Signalausgangs des Sendeempfängers einen Signalpegel auf dem Sendepfad zu erzeugen. Beispielsweise ist der Sendeempfänger ausgebildet, seinen Signalausgang in einen der Zustände "HIGH", "LOW" oder "HZ" (hochohmig) zu versetzen. Je nachdem, in welchem Zustand sich der Signalausgang des Sendeempfängers befindet, kann die Anzahl der Transistoren einen entsprechenden Signalpegel im Empfangspfad produzieren. Die Steuereinheit, deren Signaleingang an dem Empfangspfad gekoppelt ist, kann das von dem Sendeempfänger bereitgestellte Steuersignal mit den von der Anzahl der Transistoren produzierten Signalpegel empfangen.

Beispiele für konkrete Verschaltungen der Transistoren und der Feldeffekttransistoren im Empfangspfad bzw. im Sendepfad werden mit Bezug auf die Zeichnungen näher erläutert werden.

Nachfolgend sollen zunächst weitere Merkmale der Steuervorrichtung des ersten Aspektes und der Steuervorrichtung des zweiten Aspektes erläutert werden. Nachstehendes gilt ausdrücklich sowohl für die Steuervorrichtung des ersten Aspektes als auch für die Steuervorrichtung des zweiten Aspektes. Daher ist im Folgenden stets von "der Steuervorrichtung" die Rede.

Die Steuervorrichtung ist beispielsweise für einen Einsatz in einem Mehrspannungsbordnetz eines Fahrzeuges ausgebildet, beispielsweise für einen Einsatz in einem Mehrspannungsbordnetz eines PKWs.

Bei dem Mehrspannungsbordnetz handelt es sich beispielsweise um ein 12 V / 48 V-Mehrspannungsbordnetz. Beispielsweise stellt also die erste Spannungsversorgungsquelle eine erste Versorgungsspannung mit einer Spannung von etwa 12 V bereit und die zweite Spannungsversorgungsquelle eine zweite Versorgungsspannung von etwa 48 V.

Die zweite Versorgungsspannung kann also größer sein als die erste Versorgungsspannung.

Die erste Versorgungsspannung liegt mit Bezug auf den ersten Masseanschluss an und die zweite Versorgungsspannung liegt mit Bezug auf den zweiten Masseanschluss.

Der erste Masseanschluss ist beispielsweise vom zweiten Masseanschluss getrennt angeordnet, wobei beide Masseanschlüsse auf dieselbe Masse, beispielsweise Fahrzeugmasse, geschaltet sein können. Die beiden Masseanschlüsse können beispielsweise jeweils einen Massebolzen umfassen. Üblicherweise führen der erste Masseanschluss und der zweite Masseanschluss etwa dasselbe Potential. Bei einer fehlerhaften Betriebsspannungsversorgung kann es jedoch zu einem Potentialunterschied zwischen den beiden Masseanschlüssen kommen, worauf an späterer Stelle etwas näher eingegangen wird.

Wie oben bereits angedeutet, kann es sich bei der ersten Versorgungsspannung um eine Gleichspannung handeln und bei der zweiten Versorgungsspannung ebenfalls um eine Gleichspannung. Die Spannungsversorgungsquellen umfassen beispielsweise jeweils eine Batterie und/oder eine Gleichrichteranordnung, die eine Gleichspannung als erste bzw. zweite Versorgungsspannung bereitstellt.

Zum Beispiel umfasst die Steuervorrichtung einen ersten Versorgungskontakt zum Empfangen der ersten Versorgungsspannung, einen zweiten Versorgungskontakt zum Empfangen der zweiten Versorgungsspannung, einen ersten Massekontakt, der mit dem ersten Masseanschluss verbunden ist, und einen zweiten Massekontakt, der mit dem zweiten Masseanschluss verbunden ist. Besagte Kontakte der Steuervorrichtung sind beispielsweise an einem Gehäuse der Steuervorrichtung angeordnet. Zwischen dem ersten Versorgungskontakt und dem ersten Massekontakt liegt beispielsweise die erste Versorgungsspannung an und zwischen dem zweiten Versorgungskontakt und dem zweiten Massekontakt liegt beispielsweise die zweite Versorgungsspannung an.

Beispielsweise sind sowohl die Steuereinheit als auch der Sendeempfänger innerhalb des Gehäuses der Steuervorrichtung angeordnet.

Der Sendeempfänger umfasst beispielsweise einen Local-Interconnect-Network (LIN)-Transceiver. Beispielsweise ist der Sendeempfänger ein LIN-Transceiver.

Der Sendeempfänger weist beispielsweise einen ersten Masseport auf, der mit dem ersten Masseanschluss verbunden ist. Diese Verbindung kann beispielsweise über besagten ersten Massekontakt der Steuervorrichtung erfolgen. Der Sendeempfänger kann ferner einen ersten Versorgungsport aufweisen, der an die erste Spannungsversorgungsquelle gekoppelt ist. Diese Kopplung kann beispielsweise über besagten ersten Versorgungskontakt der Steuervorrichtung erfolgen. Auf diese Weise kann der Sendeempfänger von der ersten Spannungsversorgungsquelle mit Energie versorgt werden. Beispielsweise wird dem Sendeempfänger also Strom bei der ersten Versorgungsspannung zugeführt. Selbstverständlich kann in dem entsprechenden Versorgungspfad, der den Versorgungsport des Sendeempfängers an die erste Spannungsversorgungsquelle koppelt, auch ein Spannungswandler vorgesehen sein.

Der Sendeempfänger ist ausgebildet zum Kommunizieren mit einer Kommunikationskomponente des ersten Teilnetzes. Diese Kommunikationskomponente ist beispielsweise außerhalb der Steuervorrichtung angeordnet. Die Kommunikationskomponente kann beispielsweise eine Fahrzeugsteuerkomponente, eine Diagnosekomponente, eine elektronische Datenverarbeitungseinrichtung etc. umfassen. Beispielsweise ist die Kommunikationskomponente ausgebildet, gemäß dem LIN-Standard zu kommunizieren. Bei einer Ausführungsform ist der Sendeempfänger also ausgebildet, mit der Kommunikationskomponente Signale gemäß dem LIN-Standard auszutauschen. Für diese Zwecke kann der Sendeempfänger eine Kommunikationsschnittstelle umfassen, die beispielsweise über eine Anzahl von Kommunikationssignalkontakten der Steuervorrichtung mit der Kommunikationskomponente des ersten Teilnetzes verbunden ist.

Besagte Kommunikationsschnittstelle kann einen oder mehrere Pins des Sendeempfängers aufweisen. Ebenso können der Signaleingang und der Signalausgang des Sendeempfängers beispielsweise jeweils in Gestalt eines Pins ausgebildet sein.

Die Steuereinheit kann beispielsweise einen Mikrokontroller umfassen. Beispielsweise ist die Steuereinheit ein Mikrokontroller.

Die Steuereinheit ist über den zweiten Masseanschluss des zweiten Teilnetzes auf dieselbe Masse, beispielsweise Fahrzeugmasse geschaltet. Eine derartige Kopplung an den zweiten Masseanschluss kann beispielsweise über besagten zweiten Massekontakt der Steuervorrichtung erfolgen. Zum Beispiel ist dazu ein zweiter Masseport der Steuereinheit mit dem zweiten Massekontakt verbunden. Die Steuereinheit kann einen zweiten Versorgungsport aufweisen, der beispielsweise an die zweite Spannungsversorgungsquelle gekoppelt ist, so dass die Steuereinheit von der zweiten Spannungsversorgungsquelle mit Energie versorgt werden kann. Beispielsweise erfolgt besagte Ankopplung mittels besagten zweiten Versorgungskontakt der Steuervorrichtung. In dem entsprechenden Versorgungspfad zwischen dem zweiten Versorgungskontakt und dem zweiten Versorgungsport der Steuereinheit kann ein Spannungswandler vorgesehen sein, der die von der zweiten Spannungsversorgungsquelle bereitgestellte zweite Versorgungsspannung über den zweiten Versorgungskontakt empfängt und diese in eine Betriebsspannung für die Steuereinheit wandelt.

Der Signalausgang und der Signaleingang der Steuereinheit sind beispielsweise jeweils in Gestalt eines Pins ausgebildet.

Die Steuereinheit ist ausgebildet zum Steuern einer Leistungskomponente des zweiten Teilnetzes. Die Leistungskomponente umfasst beispielsweise eine Umrichteranordnung, die ein Leistungssignal, beispielsweise ein ein-oder mehrphasiges Wechselspannungssignal für einen elektrischen Motor bereitstellt. Beispielsweise steuert die Steuereinheit einen Treiber der Umrichteranordnung und die Umrichteranordnung stellt in Abhängigkeit von Treiberausgangssignalen das Leistungssignal für den zu steuernden Motor bereit. Die Leistungskomponente des zweiten Teilnetzes wird beispielsweise mit Energie von der zweiten Spannungsversorgungsquelle versorgt. Beispielsweise weist die Steuereinheit eine Steuersignalschnittstelle auf, die die Steuereinheit an die Leistungskomponente des zweiten Teilnetzes koppelt.

Der Sendeempfänger und die Steuereinheit sind operativ aneinander gekoppelt. Beispielsweise sind für diese Kopplung mehrere Steuersignalpfade vorgesehen, die jeweils in Gestalt von unidirektionalen Steuersignalpfaden ausgebildet sein können, die also eine Übertragung des Steuersignals nur in eine Richtung erlauben.

Aus Sicht der Steuereinheit handelt es sich bei wenigstens einem der Steuersignalpfade um oben erläuterten Sendepfad, über den die Übertragung eines Steuersignals von der Steuereinheit hin zum Sendeempfänger erfolgt. Bei einem anderen der Steuersignalpfade handelt es sich aus Sicht der Steuereinheit um oben erläuterten Empfangspfad, über den eine Übertragung eines Steuersignals von dem Sendeempfänger hin zur Steuereinheit erfolgt.

Weitere Merkmale und Vorteile der Steuervorrichtung, insbesondere weitere Merkmale und Vorteile des Sendepfads und des Empfangspfads, werden bei der nachfolgenden Beschreibung von Ausführungsbeispielen anhand der Figuren deutlich. Es zeigen:
- Fig. 1: eine schematische und exemplarische Darstellung eines Teils eines Mehrspannungsbordnetzes mit einer Steuervorrichtung gemäß einer oder mehreren Ausführungsformen;
- Fig. 2: eine schematische und exemplarische Darstellung von Komponenten einer Steuervorrichtung gemäß einer oder mehreren Ausführungsformen;
- Fig. 3: eine schematische und exemplarische Darstellung von Komponenten einer Steuervorrichtung gemäß einer oder mehreren Ausführungsformen;
- Fig. 4: eine schematische und exemplarische Darstellung von Komponenten einer Steuervorrichtung gemäß einer oder mehreren Ausführungsformen.

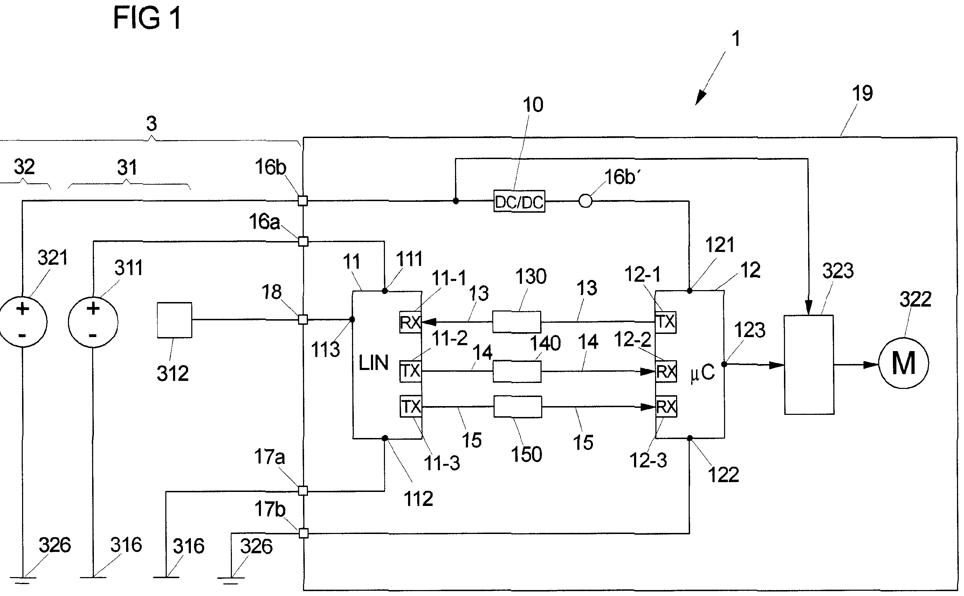

Fig. 1 zeigt eine schematische und exemplarische Darstellung eines Teils eines Mehrspannungsbordnetzes 3 mit einer Steuervorrichtung gemäß einer oder mehrerer Ausführungsformen.

Bei dem Mehrspannungsbordnetz 3 handelt es sich beispielsweise um ein Mehrspannungsbordnetz eines Fahrzeugs, beispielsweise eines PKWs. Das Mehrspannungsbordnetz 3 umfasst ein erstes Teilnetz 31 und ein zweites Teilnetz 32. Das erste Teilnetz 31 wird von einer ersten Spannungsversorgungsquelle 311 mit einer ersten Versorgungsspannung betrieben und das zweite Teilnetz 32 wird von einer zweiten Spannungsversorgungsquelle 321 mit einer zweiten Versorgungsspannung betrieben.

Die erste Spannungsversorgungsquelle 311 umfasst beispielsweise eine erste Batterie und/oder eine erste Gleichrichteranordnung. Beispielsweise stellt die erste Spannungsversorgungsquelle 311 eine Gleichspannung von etwa 12 V bereit.

Die zweite Spannungsversorgungsquelle 321 umfasst beispielsweise eine zweite Batterie und/oder eine zweite Gleichrichteranordnung. Beispielsweise stellt die zweite Spannungsversorgungsquelle 321 eine Gleichspannung von etwa 48 V bereit.

Die erste Versorgungsspannung liegt gegenüber einem ersten Masseanschluss 316 an und die zweite Versorgungsspannung liegt gegenüber einem zweiten Masseanschluss 326 an.

Die beiden Masseanschlüsse 316 und 326 können jeweils in Gestalt von Massebolzen oder ähnlichem vorliegen. Üblicherweise ist der erste Masseanschluss 316 getrennt von dem zweiten Masseanschluss 326 angeordnet. Beide Masseanschlüsse 316 und 326 sind auf dieselbe Masse geschaltet, beispielsweise die Fahrzeugmasse. Üblicherweise führen die beiden Masseanschlüsse 316 und 326 dasselbe Potential. Kommt es jedoch zu einer fehlerhaften Betriebsspannungsversorgung, kann es vorkommen, dass ein Potentialunterschied zwischen den beiden Masseanschlüssen 316 und 326 entsteht, worauf an späterer Stelle etwas näher eingegangen werden wird.

Das erste Teilnetz 31 umfasst ferner eine Kommunikationskomponente 312. Beispielsweise ist die Kommunikationskomponente 312 ausgebildet, Signale entsprechend dem LIN-Standard bereitzustellen und zu empfangen. Beispielsweise umfasst die Kommunikationskomponente 312 eine Fahrzeugsteueranordnung, eine elektronische Datenverarbeitungseinrichtung, eine Diagnoseeinrichtung und/oder dergleichen.

Das zweite Teilnetz 32 umfasst bei dem in der Fig. 1 dargestellten Beispiel einen elektrischen Motor 322 sowie eine Umrichteranordnung 323, die beispielsweise einen leistungselektronischen Umrichter und einen zur Steuerung des leistungselektronischen Umrichters vorgesehenen Treiber umfasst. Die Umrichteranordnung 323 wird mit Energie von der zweiten Spannungsversorgungsquelle 321 versorgt. Beispielsweise empfängt die Umrichteranordnung 323 die von der zweiten Spannungsversorgungsquelle 321 bereitgestellte zweite Versorgungsspannung und wandelt diese in ein Spannungssignal, beispielsweise ein Wechselspannungssignal, für den elektrischen Motor 322.

Die Steuervorrichtung 1 umfasst einen Sendeempfänger 11 und eine Steuereinheit 12. Der Sendeempfänger 11 umfasst beispielsweise einen LIN-Transceiver. Beispielsweise ist der Sendeempfänger 11 ein LIN-Transceiver. Die Steuereinheit 12 umfasst beispielsweise einen Mikrocontroller (µC). Beispielsweise ist die Steuereinheit 12 ein Mikrocontroller.

Der Sendeempfänger 11 und die Steuereinheit 12 können in einem Gehäuse 19 der Steuervorrichtung 1 angeordnet sein. Die Steuervorrichtung 1 umfasst beispielsweise einen ersten Versorgungskontakt 16a zum Empfangen der ersten Versorgungsspannung, einen zweiten Versorgungskontakt 16b zum Empfangen der zweiten Versorgungsspannung, einen ersten Massekontakt 17a, der mit der ersten Masseanschluss 316 verbunden ist, sowie einem zweiten Masseanschluss 17b, der mit dem zweiten Masseanschluss 326 verbunden ist. Besagte Kontakte 16a, 16b, 17a und 17b können am Gehäuse 19 der Steuervorrichtung 1 angeordnet sein.

Zwischen dem ersten Versorgungskontakt 16a und dem ersten Massekontakt 17a liegt beispielsweise die erste Versorgungsspannung an und zwischen dem zweiten Versorgungskontakt 16b und dem zweiten Massekontakt 17b liegt beispielsweise die zweite Versorgungsspannung an.

Der Sendeempfänger 11 umfasst einen ersten Versorgungsport 111, der an die erste Spanungsversorgungsquelle 311 gekoppelt ist. Diese Kopplung erfolgt beispielsweise über besagten ersten Versorgungskontakt 16a. Ferner umfasst der Sendeempfänger 11 einen ersten Masseport 112, der an den Masseanschluss 316 gekoppelt ist. Diese Kopplung erfolgt beispielsweise über besagten ersten Massekontakt 17a der Steuervorrichtung 1. Auf diese Weise kann der Sendeempfänger 11 mit Energie von der ersten Spannungsversorgungsquelle 311 versorgt werden. Zwischen der ersten Spannungsversorgungsquelle 311 und dem ersten Versorgungsport 111 kann ein in den Figuren nicht dargestellter Spannungswandler vorgesehen sein, der die von der ersten Versorgungsquelle 311 produzierte erste Versorgungsspannung in eine Betriebsspannung für den Sendeempfänger 11 umwandelt.

Der Sendeempfänger 11 ist ausgebildet zum Kommunizieren mit der Kommunikationskomponente 312 des ersten Teilnetzes. Beispielsweise umfasst der Sendeempfänger 11 eine Kommunikationsschnittstelle 113, die über eine Anzahl von Kommunikationskontakten 18 der Steuervorrichtung 1 mit der Kommunikationskomponente 312 des ersten Teilnetzes 31 verbunden sein kann. Beispielsweise umfasst die Kommunikationsschnittstelle 113 eine Anzahl von Pins. Zum Beispiel tauscht der Sendeempfänger 11 mit der Kommunikationskomponente 312 Signale gemäß dem LIN-Standard aus. Der Sendeempfänger 11 kann also dem ersten Teilnetz 31 zugeordnet sein.

Die Steuereinheit 12 umfasst einen zweiten Versorgungsport 121, der an die zweite Spannungsversorgungsquelle 321 gekoppelt ist. Beispielsweise erfolgt diese Kopplung über besagten zweiten Versorgungskontakt 16b der Steuervorrichtung 1. Zwischen der zweiten Spannungsversorgungsquelle 321 und dem zweiten Versorgungsport 121 der Steuereinheit 12 kann ein Spannungswandler 10 vorgesehen sein, der die von der zweiten Spannungsversorgungsquelle 321 bereitgestellte zweite Versorgungsspannung in eine Betriebsspannung für die Steuereinheit 12 wandelt. Beispielsweise stellt der Spannungswandler 10 die Betriebsspannung, sprich: die gewandelte zweite Versorgungsspannung, an einem Spannungswandlerausgang 16b' bereit. Andererseits umfasst die Steuereinheit 12 einen zweiten Masseport 122, der an den zweiten Masseanschluss 326 gekoppelt ist. Diese Kopplung erfolgt beispielsweise über besagten zweiten Massekontakt 17b der Steuervorrichtung 1. Auf diese Weise kann die Steuereinheit 12 mit Energie von der zweiten Spannungsversorgungsquelle 321 versorgt werden.

Die Steuereinheit 12 ist ausgebildet zum Steuern einer Leistungskomponente des zweiten Teilnetzes 32, beispielsweise zum Betreiben des elektrischen Motors 322 mittels der Umrichteranordnung 323. Für diese Zwecke weist die Steuereinheit 12 beispielsweise eine Steuersignalschnittstelle 123 auf, mittels derer die Steuereinheit 12 die Umrichteranordnung 323, beispielsweise einen Treiber der Umrichteranordnung 323, steuern kann. Beispielsweise wandelt die Umrichteranordnung 323 in Abhängigkeit von den an der Steuersignalschnittstelle 123 anliegenden Signalen die von der zweiten Spannungsversorgungsquelle 321 produzierte zweite Versorgungsspannung in eine ein-oder mehrphasige Wechselspannung für den elektrischen Motor 322.

Der elektrische Motor 322 dient beispielsweise für einen Antrieb des Fahrzeugs, beispielsweise zum Öffnen und Schließen einer Heckklappe des Fahrzeugs, zum Öffnen und Schließen eines Fensters des Fahrzeugs, zum Betreiben einer Bremse des Fahrzeugs, oder zur Realisierung eines Vortriebs des Fahrzeugs.

Der Sendeempfänger 11 und die Steuereinheit 12 sind operativ aneinander gekoppelt. Für diese Kopplung ist eine Anzahl von Steuersignalpfaden vorgesehen, von denen in der Fig. 1 drei Steuersignalpfade 13, 14 und 15 dargestellt sind, wobei bei anderen Ausführungsformen auch mehr oder weniger als die drei Steuersignalpfade 13, 14 und 15 vorgesehen sein können.

Jeder der Steuersignalpfade 12, 14 und 15 koppelt einen Signalausgang (jeweils als TX gekennzeichnet) an einen Signaleingang (jeweils als RX bezeichnet). Bei den Steuersignalpfaden 13, 14 und 15 kann es sich jeweils um unidirektionale Steuersignalpfade handeln, die ausgebildet sind, ein Steuersignal jeweils nur von einem Signalausgang hin zu einem Signaleingang zu übertragen, jedoch nicht in umgekehrte Richtung.

Zum Beispiel koppelt der erste Steuersignalpfad 13 einen ersten Signalausgang 12-1 der Steuereinheit an einen ersten Signaleingang 11-1 des Sendeempfängers 11. Aus Sicht der Steuereinheit handelt es sich bei diesem Steuersignalpfad 13 um einen Sendepfad. Im Folgenden ist meist von dem "Sendepfad 13" die Rede.

Ferner kann der zweite Steuersignalpfad 14 einen zweiten Signalausgang 11-2 des Sendeempfängers 11 an einen zweiten Signaleingang 12-2 der Steuereinheit 12 koppeln. Aus Sicht der Steuereinheit 12 handelt es sich bei diesem Steuersignalpfad 14 um einen Empfangspfad, der im Folgenden meist als "erster Empfangspfad 14" bezeichnet werden wird.

Außerdem koppelt beispielsweise der dritte Steuersignalpfad 15 einen dritten Signalausgang 11-3 des Sendeempfängers 11 an einen dritten Signaleingang 12-3 der Steuereinheit 12. Aus Sicht der Steuereinheit 12 handelt es sich bei diesem dritten Steuersignalpfad 15 ebenfalls um einen Empfangspfad, der im Folgenden meist als "zweiter Empfangspfad 15" bezeichnet werden wird.

Der Sendepfad 13 ist beispielsweise ausgebildet, ein von der Steuereinheit 12 am ersten Signalausgang 12-1 bereitgestelltes Steuersignal hin zum ersten Signaleingang 11-1 des Sendeempfängers 11 zu übertragen. In ähnlicher Weise kann der erste Empfangspfad 14 ausgebildet sein, ein vom Sendeempfänger 11 am zweiten Signalausgang 11-2 bereitgestellte Steuersignal hin zum zweiten Signaleingang 12-2 der Steuereinheit 12 zu übertragen. Ebenso kann der zweite Empfangspfad 15 ausgebildet sein, ein weiteres vom Sendeempfänger 11 am dritten Signalausgang 11-3 bereitgestelltes Steuersignal hin zum dritten Signaleingang 12-3 der Steuereinheit 12 zu übertragen.

Der erste Signaleingang 11-1, der zweite Signalausgang 11-2 und der dritte Signalausgang 11-3 liegen beispielsweise jeweils in Gestalt eines Pins vor, beispielsweise in Gestalt eines Pins eines LIN-Transceivers vor. Der erste Signalausgang 12-1, der zweite Signaleingang 12-2 sowie der dritte Signaleingang 12-3 der Steuereinheit 12 liegen beispielsweise jeweils in Gestalt eines Pins vor, beispielsweise in Gestalt eines Pins eines Mikrocontrollers.

Beispielsweise ist der Sendeempfänger 11 ausgebildet, den ersten Signaleingang 11-1 in den Zustand "HZ" zu versetzen, um das vom Sendepfad 13 übertragene Steuersignal zu empfangen. Der Sendeempfänger 11 kann ferner ausgebildet sein, den zweiten Signalausgang 11-2 wahlweise in einen der Zustände "LOW", "HIGH", "HZ" zu versetzen, um ein Steuersignal mittels des ersten Empfangspfades 14 hin zur Steuereinheit 12 zu übertragen. Ebenso kann der Sendeempfänger 11 ausgebildet sein, den dritten Signalausgang 11-3 wahlweise in einen der Zustände "LOW", "HIGH" oder "HZ" zu versetzen, um eine Steuersignal über den zweiten Empfangspfad hin zur Steuereinheit 12 zu übertragen.

Beispielsweise ist die Steuereinheit 12 ausgebildet, den zweiten Signaleingang 12-2 sowie den dritten Signaleingang 12-3 jeweils in den Zustand "HZ" zu versetzen, um das mittels des ersten Empfangspfades 14 bzw. mittels des zweiten Empfangspfades 15 übertragene Steuersignal zu empfangen. Ferner kann die Steuereinheit 12 ausgebildet sein, den ersten Signalausgang 12-1 wahlweise in einen der Zustände "LOW", "HIGH" oder "HZ" zu versetzen, um ein Steuersignal über den Sendepfad 13 hin zum Sendeempfänger 11 zu übertragen.

Der Sendepfad 13 kann ein erstes Schaltungsmodul 130 umfassen. Der erste Empfangspfad 14 kann ein zweites Schaltungsmodul 140 umfassen und der zweite Empfangspfad 15 ein drittes Schaltungsmodul 150.

Die Schaltungsmodule 130, 140 und 150 können jeweils wenigstens eine Diode und eine Anzahl von Transistoren umfassen, damit bei der Signalübertragung bestimmte sicherheitsrelevante Funktionen und/oder Anforderungen hinsichtlich einer Signalqualität und/oder Anforderungen hinsichtlich eines Signal-Timings erfüllt werden können.

Allgemein gesprochen kann jedes der Schaltungsmodule 130, 140 und 150 ausgebildet sein, auf eine fehlerhafte Betriebsspannungsversorgung im ersten Teilnetz 31 und/oder im zweiten Teilnetz 32 hin einen sperrenden Zustand einzunehmen, bei dem die Übertragung des Steuersignals über den betreffenden Steuersignalpfad 13, 14 bzw. 15 unterbunden wird. Liegt also beispielsweise eine fehlerhafte Betriebsspannungsversorgung vor, so kann jedes der Schaltungsmodule 130, 140 und 150 ausgebildet sein, den entsprechenden Pfad 13, 14 bzw. 15 zu sperren, so dass die Signalübertragung unterbunden wird.

Die fehlerhafte Betriebsspannungsversorgung liegt beispielsweise dann vor, wenn wenigstens eines des Folgenden zutrifft:
- Der Sendeempfänger 11 ist nicht mehr auf Masse geschaltet;
- die Steuereinheit 12 ist nicht mehr auf Masse geschaltet;
- ein Kurzschluss im ersten Teilnetz 31 und/oder im zweiten Teilnetz 32;
- ein Potentialunterschied zwischen dem ersten Masseanschluss 316 und dem Masseanschluss 326 überschreitet einen Schwellenwert.

Der letztgenannte Fehlerfall wird beispielsweise auch als Masseversatz bezeichnet. Der Schwellenwert kann beispielsweise bei betragsmäßig 1 V liegen. Durch entsprechende Dimensionierung der Komponenten der Schaltungsmodule 130, 140 und 150 kann dieser Wert jedoch auch verändert werden.

Die erstgenannten beiden Fehlerfälle (der Sendeempfänger 11 ist nicht mehr auf Masse geschaltet bzw. die Steuereinheit 12 ist nicht mehr auf Masse geschaltet) werden gelegentlich auch als Masseabriss bezeichnet.

Insbesondere kann jedes der Schaltungsmodule 130, 140 und 150 ausgebildet sein, einen Durchschlag von dem Teilnetz mit der höheren Versorgungsspannung, beispielsweise das zweite Teilnetz 32, in das Teilnetz mit der niedrigeren Versorgungsspannung, beispielsweise das erste Teilnetz 31, über den betreffenden Steuersignalpfad 13, 14 bzw. 15 zu verhindern. Für diese Zwecke kann insbesondere jedes der Schaltungsmodule 130, 140 und 150 besagte Diode aufweisen.

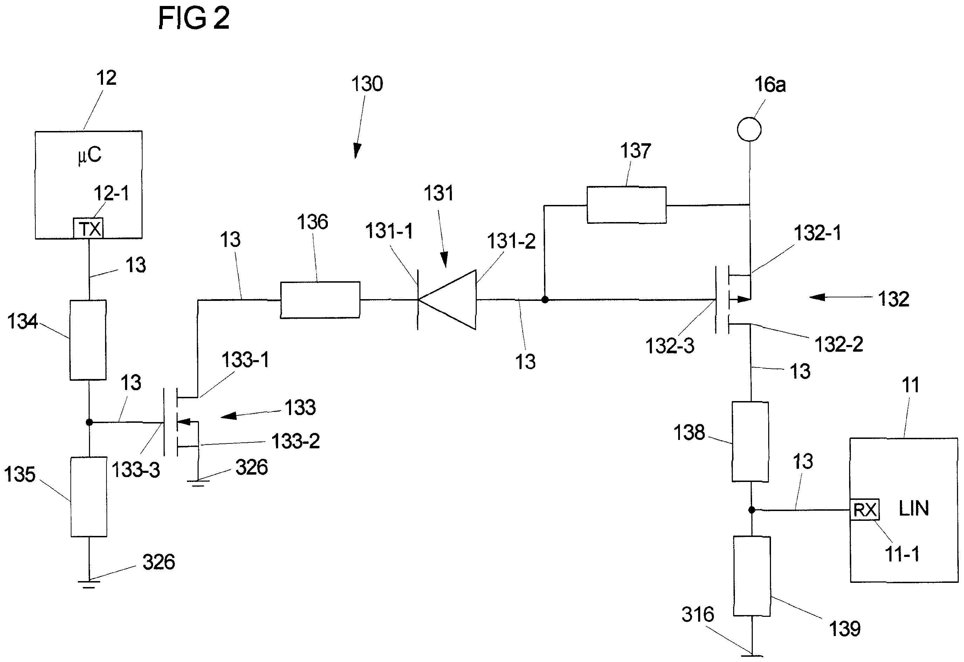

Konkrete Beispiele von Konfigurationen des ersten Schaltungsmoduls 130, des zweiten Schaltungsmoduls 140 und des dritten Schaltungsmoduls 150 werden nun mit Bezug auf die Fig. 2 bis Fig. 4 erläutert werden.

Fig. 2 zeigt eine schematische und exemplarische Darstellung des ersten Schaltungsmoduls 130. Das erste Schaltungsmodul 130 ist wenigstens teilweise dem Sendepfad 13 angeordnet.

Das erste Schaltungsmodul 130 umfasst eine Diode 131, deren Kathodenanschluss 131-1 an den zweiten Masseanschluss 326 gekoppelt ist. Ferner umfasst das erste Schaltungsmodul 130 eine Anzahl von Feldeffekttransistoren 132 und 133 wobei die Anzahl von Feldeffekttransistoren 132 und 133 den Sendepfad 13 einerseits an die erste Spannungsversorgungsquelle 311 koppelt und andererseits an den ersten Masseanschluss 321 und an den zweiten Masseanschluss 326.

Beispielsweise erfolgt die Ankopplung des Kathodenanschlusses 131-1 der im Sendepfad 13 angeordneten Diode 131 an den zweiten Masseanschluss 326 über den zweiten Feldeffekttransistor 133, wobei dazu auch ein ohmscher Widerstand 136 angeordnet sein kann. Der Kathodenanschluss 131-1 führt über den ohmschen Widerstand 136 hin zu einem ersten Signalanschluss 133-1 des zweiten Feldeffekttransistors 133.

Ein zweiter Signalanschluss 133-2 des zweiten Feldeffekttransistors 133 ist auf den zweiten Masseanschluss 326 geschaltet, wobei diese Verbindung beispielsweise über besagten zweiten Massekontakt 17b erfolgen kann. Ein Steueranschluss 133-3 des zweiten Feldeffekttransistors 133 ist einerseits über einen Widerstand 134 an den ersten Signalausgang 12-1 der Steuereinheit gekoppelt. Andererseits ist der Steueranschluss 133-3 über einen weiteren ohmschen Widerstand 135 an den zweiten Masseanschluss 326 gekoppelt. Die beiden ohmschen Widerstände 134 und 135 sind optional; der Steueranschluss 133-3 könnte auch direkt mit dem ersten Signalausgang 12-1 und direkt mit dem zweiten Masseanschluss 326 verbunden sein.

Mit dem ersten Feldeffekttransistor 132 ist der Sendepfad 13 an die erste Spannungsversorgungsquelle 311 gekoppelt. Diese Kopplung erfolgt beispielsweise mittels besagten ersten Versorgungskontakt 16a.

Ein Anodenanschluss 131-2 der Diode 131 ist zum einen direkt mit einem Steueranschluss 132-3 des ersten Feldeffekttransistors 132 verbunden und zum anderen über einen ohmschen Widerstand 137 mit der ersten Spannungsversorgungsquelle 311, und zwar beispielsweise über besagten ersten Versorgungskontakt 16a, der auch an den ersten Signalanschluss 132-1 angeschlossen sein kann. Ein zweiter Signalanschluss 132-2 des ersten Feldeffekttransistors 132 ist an den ersten Signaleingang 11-1 des Sendeempfängers 11 angeschlossen, beispielsweise über einem weiteren ohmschen Widerstand 138, wobei dieser ohmsche Widerstand 138 optional ist; der zweite Signalanschluss 132-2 könnte auch direkt mit dem ersten Signaleingang 11-1 verbunden sein. Ferner ist der erste Signaleingang 11-1 des Sendeempfängers 11 über einen weiteren ohmschen Widerstand 139 mit dem ersten Masseanschluss 316 verbunden.

Die Verbindung zwischen dem Sendepfad 13 und den beiden Masseanschlüssen 316 und 326 kann insbesondere auch über die in der Fig. 2 nicht dargestellten Massekontakte 17a und 17b.

Die Diode 131 kann ausgebildet sein, einen Stromfluss von dem zweiten Teilnetz 32 hin zum ersten Teilnetz 31 über den Sendepfad 13 zu sperren. Das zweite Teilnetz 32 kann, wie gesagt, das Teilnetz sein, das mit der höheren Versorgungsspannung betrieben wird.

Über die beiden Feldeffekttransistoren 132 und 133 kann ein Pegel für das Steuersignal erzeugt werden, dass von dem ersten Signalausgang 12-1 hin zum ersten Signaleingang 11-1 des Sendeempfängers übertragen werden soll.

Mittels der beiden Feldeffekttransistoren 132 und 133 kann ein Signalpegel für das über den Sendepfad 13 zu übertragene Steuersignal bereitgestellt werden. Beispielsweise steuert die Steuereinheit 12 durch wahlweises versetzen des ersten Signalausgangs 12-1 in einen der besagten Zustände "LOW", "HIGH" oder "HZ" die beiden Feldeffekttransistoren 132 und 133. Beispielsweise können diese Feldeffekttransistoren 132 und 133 in Abhängigkeit von dem Zustand des ersten Signalausgangs 12-1 eingeschaltet (leitend) oder ausgeschaltet (sperrend) werden.

Die Feldeffekttransistoren 132 und 133 haben gegenüber vergleichbaren Bipolartransistoren haben den Vorteil, dass diese vergleichsweise schnell geschaltet werden können.

Somit eignet sich der Sendepfad 13 mit den ersten Schaltungsmodul 130 insbesondere zur Übertragung von dynamischen Signalen, also Signalen, deren Pegel sich vergleichsweise schnell und häufig ändern soll.

Die beiden Feldeffekttransistoren 132 und 133 sind beispielsweise jeweils als MOSFET implementiert. Der erste Feldeffekttransistor 132 ist beispielsweise als selbstsperrender p-Kanal MOSFET ausgestaltet. In dieser Variante ist der erste Signalanschluss 132-1 ein Source-Anschluss, der zweite Signalanschluss 132-2 ein Drain-Anschluss und der Steueranschluss 132-3 ein Gate-Anschluss. Der zweite Feldeffekttransistor 132 ist beispielsweise als selbstsperrenden n-Kanal MOSFET ausgebildet. Bei dieser Variante ist der erste Signalanschluss 133-1 als Drain-Anschluss ausgebildet, der zweite Signalanschluss 133-2 als Source-Anschluss und der Steueranschluss 133-3 als Gate-Anschluss.

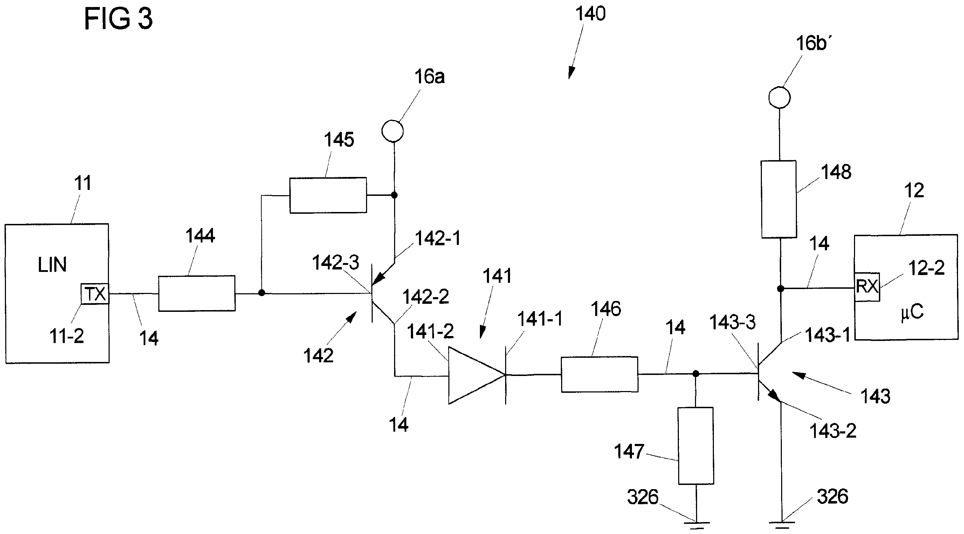

Fig. 3 zeigt eine schematische und exemplarische Darstellung des zweiten Schaltungsmoduls 140, das wenigstens teilweise im ersten Empfangspfad 14 angeordnet ist.

Das zweite Schaltungsmodul 140 weist eine im ersten Empfangspfad 14 angeordnete Diode 141 auf, deren Kathodenanschluss 141-1 an den zweiten Masseanschluss 326 gekoppelt ist. Ferner weist das zweite Schaltungsmodul 140 eine Anzahl von Transistoren 142 und 143 auf, wobei die Anzahl von Transistoren 142 und 143 den ersten Empfangspfad einerseits an die erste Spannungsversorgungsquelle 311 und an die zweite Spannungsversorgungsquelle 321 koppelt und andererseits an den zweiten Masseanschluss 326.

Beispielsweise ist der Kathodenanschluss 141-1 mit Hilfe von ohmschen Widerständen 146 und 147 an den zweiten Masseanschluss 326 gekoppelt. Die Verbindung zwischen dem ohmschen Widerstand 147 und dem zweiten Masseanschluss 326 kann wiederum über besagten zweiten Massekontakt 17b erfolgen.

Die Ankopplung des ersten Empfangspfads 14 an die erste Spannungsversorgungsquelle 311 erfolgt beispielsweise mittels des ersten Transistors 142, dessen erster Signalanschluss 142-1 beispielsweise an den besagten ersten Versorgungskontakt 16a angeschlossen ist.

Die Ankopplung an die zweite Spannungsversorgungsquelle 321 erfolgt beispielsweise mittels eines ohmschen Widerstands 148 sowie des in der Fig. 3 nicht dargestellten Spannungswandlers 10, der an seinem Spannungswandlerausgang 16b' eine gewandelte zweite Versorgungsspannung bereitstellt.

Der ohmsche Widerstand 148 ist sowohl an den zweiten Signaleingang 12-2 der Steuereinheit 12 gekoppelt als auch an einen ersten Signalanschluss 143-1 des zweiten Transistors 143. Ein zweiter Signalanschluss 143-2 des zweiten Transistors 143 ist direkt an den zweiten Masseanschluss 326 gekoppelt. Diese Kopplung kann wiederum mittels des zweiten Massekontakts 17b erfolgen. Ein Steueranschluss 143-3 ist über den bereits erwähnten ohmschen Widerstand 147 ebenfalls an den zweiten Masseanschluss 326 angeschlossen.

Der zweite Signalausgang 11-2 des Sendeempfängers 11 ist über einen ohmschen Widerstand 144 an einen Steueranschluss 142-3 des ersten Transistors 142 angeschlossen. Der bereits erwähnte erste Signalanschluss 142-1 des ersten Transistors 142 ist über einen noch weiteren ohmschen Widerstand 145 mit dem Steueranschluss 142-3 des ersten Transistors 142 verbunden. Ein zweiter Signalanschluss 142-2 ist direkt mit einem Anodenanschluss 141-2 dem ersten Empfangspfad 14 angeordneten Diode 141 verbunden.

Die im ersten Empfangspfad 14 angeordnete Diode 141 kann ausgebildet sein, einen Strom von dem zweiten Teilnetz 32 hin zum ersten Teilnetz 31 über den ersten Empfangspfad 14 zu sperren. Ein Stromfluss über den ersten Empfangspfad 14 ist aufgrund der Diode 141 beispielsweise nur in die umgekehrte Richtung möglich.

Mittels der beiden Transistoren 142 und 143 kann ein Signalpegel für das über den ersten Empfangspfad 14 zu übertragene Steuersignal bereitgestellt werden. Beispielsweise steuert der Sendeempfänger 11 durch wahlweises versetzen des zweiten Signalausgangs 11-2 in einen der besagten Zustände "LOW", "HIGH" oder "HZ" die beiden Transistoren 142 und 143. Beispielsweise können diese Transistoren 142 und 143 in Abhängigkeit von dem Zustand des zweiten Signalausgangs 11-2 eingeschaltet (leitend) oder ausgeschaltet (sperrend) werden.

Das wenigstens teilweise im ersten Empfangspfad 14 angeordnete zweite Schaltungsmodul 140 eignet sich beispielsweise zur Übertragung von weniger dynamischen Signalen, wie beispielsweise ein WAKE-UP-Signal. Beispielsweise sind die beiden Transistoren 142 und 143 jeweils als Bipolartransistoren ausgebildet. Der erste Transistor 142 ist beispielsweise ein pnp-Transistor. In dieser Variante ist der erste Signalanschluss 142-1 ein Emitter-Anschluss, der zweite Signalanschluss 142-2 ein Kollektor-Anschluss und der Steueranschluss 142-3 ein Basis-Anschluss.

Der zweite Transistor 143 ist beispielsweise ein npn-Transistor. Bei dieser Variante ist der erste Signalanschluss 143-1 ein Kollektor-Anschluss, der zweite Signalanschluss 143-2 ein Emitter-Anschluss und der Steueranschluss 143-3 ein Basis-Anschluss.

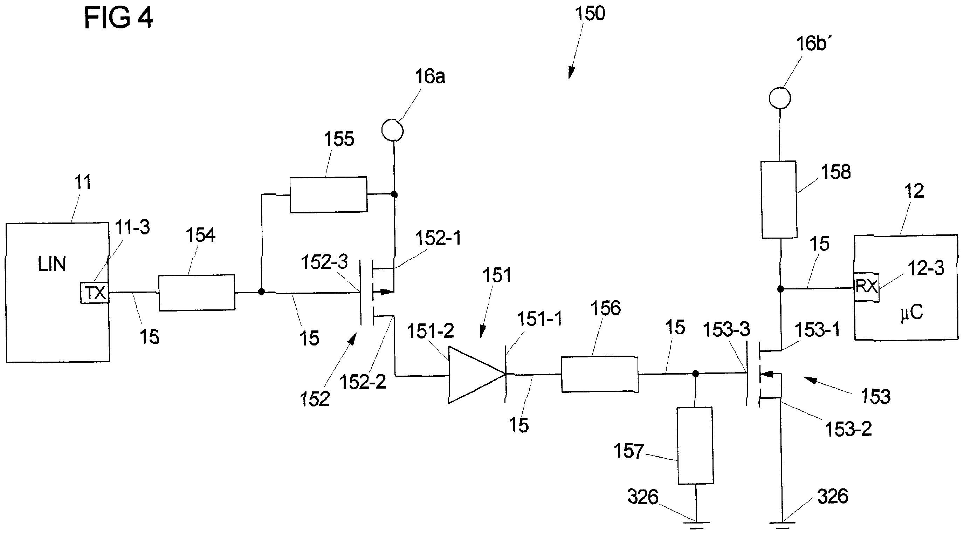

Fig. 4 zeigt eine schematische und exemplarische Darstellung des dritten Schaltungsmoduls 150, das wenigstens teilweise in dem zweiten Empfangspad 15 angeordnet ist.

Das dritte Schaltungsmodul 150 umfasst eine im zweiten Empfangspfad 15 angeordnete Diode 151, deren Kathodenanschluss 151-1 an den zweiten Masseanschluss 326 gekoppelt ist. Ferner umfasst das dritte Schaltungsmodul 150 eine Anzahl von Transistoren 152 und 153, wobei die Anzahl von Transistoren 152 und 153 den zweiten Empfangspfad 15 einerseits an die erste Spannungsversorgungsquelle 311 und an die zweite Spannungsversorgungsquelle 321 koppelt und andererseits an den zweiten Masseanschluss 326.

Beispielsweise ist der Kathodenanschluss 151-1 der Diode 151 über ohmsche Widerstände 156 und 157 an den zweiten Masseanschluss 326 gekoppelt, wobei der ohmsche Widerstand 156 optional ist. Über den optionalen Widerstand 156 ist der Kathodenanschluss 151-1 der Diode 151 an einen Steueranschluss 153-3 des zweiten Transistors 153 angeschlossen. Ist der ohmsche Widerstand 156 nicht vorgesehen, so ist der Kathodenanschluss 151-1 direkt mit dem Steueranschluss 153-3 verbunden. Der Steueranschluss 153-3 des zweiten Transistors 153 ist über besagten ohmschen Widerstand 157 an den zweiten Masseanschluss gekoppelt.

Im Übrigen entspricht die Verschaltung des dritten Schaltungsmoduls 150 im Wesentlichen der Verschaltung des in der Fig. 3 exemplarisch dargestellten zweiten Schaltungsmoduls 140. Insoweit wird auf das Vorstehende verwiesen.

Beispielsweise ist also der zweite Empfangspfad 15 über den ersten Transistors 152 an die erste Spannungsversorgungsquelle 321 gekoppelt, wobei diese Kopplung insbesondere über den besagten ersten Versorgungskontakt 16a erfolgen kann.

Eine Ankopplung des zweiten Empfangspfads 15 an die zweite Spannungsversorgungsquelle 321 erfolgt beispielsweise über einen weiteren ohmschen Widerstand 158, der an den Spannungswandlerausgang 16b' angeschlossen sein kann, welcher die gewandelte zweite Versorgungsspannung führen kann.

Auf Seiten der Steuereinheit 12 ist der dritte Signaleingang 12-3 an einen ersten Steueranschluss 153-1 des zweiten Transistors 153 angeschlossen. Ein zweiter Signalanschluss 153-2 des zweiten Transistors 153 ist an den zweiten Masseanschluss 326 gekoppelt.

Auf Seiten des Sendeempfängers 11 ist der dritte Signalausgang 11-3 über einen ohmschen Widerstand 154 an einen Steueranschluss 152-3 des ersten Transistors 152 gekoppelt. Ein weiterer ohmscher Widerstand 155 verbindet den Steueranschluss 152-3 mit einem ersten Signalanschluss 152-1 des ersten Transistors 152. Ein zweiter Signalanschluss 152-2 ist mit einem Anodenanschluss 151-2 der Diode 151 verbunden.

Beispielsweise sind die beiden Transistoren 152 und 153 ausgebildet, einen Pegel für das über den zweiten Empfangspfad 15 zu übertragene Signal zu erzeugen. Beispielsweise steuert der Sendeempfänger 11 die beiden Transistoren 152 und 153 durch wahlweises Versetzen des dritten Signalausgangs 11-1 in einen der besagten Zustände "LOW", "HIGH" oder "HZ". Beispielsweise werden die Transistoren 152, 153 dadurch entweder eingeschaltet (leitend) oder ausgeschaltet (sperrend).

Bei dem zweiten Empfangspfad 15 sind die beiden Transistoren 152 und 153 des dritten Schaltungsmoduls 150 jeweils als Feldeffekt-Transistoren, beispielsweise als MOSFET ausgebildet. Der zweite Empfangspfad 15 eignet sich damit beispielsweise für die Übertragung vergleichsweise dynamischer Steuersignale, deren Pegel sich vergleichsweise schnell und häufig ändern soll.

Der erste Transistor 152 ist beispielsweise als selbstsperrender p-Kanal MOSFET ausgebildet. Bei dieser Variante ist der erste Signalanschluss 152-1 ein Source-Anschluss, der zweite Signalanschluss 152-2 ein Drain-Anschluss und der Steueranschluss 152-3 ein Gate-Anschluss.

Der zweite Transistor 153 ist beispielsweise als selbstsperrender n-Kanal MOSFET ausgebildet. Diese Variante ist der erste Signalanschluss 153-1 ein Drain-Anschluss, der zweite Signalanschluss 153-2 ein Source-Anschluss und der Steueranschluss 153-3 des zweiten Transistors 153 ein Gate-Anschluss.

Bei einer Ausführungsform der Steuervorrichtung 1 sind der Sendeempfänger 11 und die Steuereinheit 12 wenigstens über den Sendepfad 13, den ersten Empfangspfad 14 und den zweiten Empfangspfad 15 operativ aneinander gekoppelt, wobei in dem Sendepfad 13 das erste Schaltungsmodul 130 wenigstens teilweise enthalten ist, in dem ersten Empfangspfad 14 das zweite Schaltungsmodul 140 wenigstens teilweise enthalten ist und in dem zweiten Empfangspfad 15 das dritte Schaltungsmodul 150 wenigstens teilweise enthalten ist, wobei das erste Schaltungsmodul 130 beispielsweise wie in Fig. 2 dargestellt ausgebildet ist, das zweite Schaltungsmodul 140 beispielsweise wie in der Fig. 3 dargestellt ausgestaltet ist und das dritte Schaltungsmodul 150 beispielsweise wie in der Fig. 4 dargestellt ausgestaltet ist. Darüber hinaus können zur Schaffung der operativen Kopplung des Sendeempfängers 11 an die Steuereinheit 12 weitere Steuersignalpfade vorgesehen sein.

Vorstehend wurde stets das bekannte 12 V / 48 V Mehrspannungsbordnetz eines Fahrzeuges als Beispiel für ein Mehrspannungsbornetz bemüht. Selbstverständlich ist die vorliegende Erfindung jedoch nicht auf derartige Mehrspannungsbordnetze beschränkt. Vielmehr können auch andere Spannungsniveaus als das 12 V-Niveau oder das 48 V-Niveau Anwendung finden.

### Bezugszeichenliste

- 1: Steuervorrichtung

- 10: Spannungswandler

- 11: Sendeempfänger
- 11-1: Erster Signaleingang
- 11-2: Zweiter Signalausgang
- 11-3: Dritter Signalausgang
- 111: Erster Versorgungsport
- 112: Erster Masseport
- 133: Kommunikationsschnittstelle

- 12: Steuereinheit
- 12-1: Erster Signalausgang
- 12-2: Zweiter Signaleingang
- 12-3: Dritter Signaleingang
- 121: Zweiter Versorgungsport
- 122: Zweiter Masseport
- 123: Steuersignalschnittstelle

- 13: Sendepfad
- 130: Erstes Schaltungsmodul
- 131: Diode
- 131-1: Kathodenanschluss der Diode
- 131-2: Anodenanschluss der Diode
- 132: Erster Feldeffekttransistor
- 132-1: Erster Signalanschluss des ersten Feldeffekttransistors
- 132-2: Zweiter Signalanschluss des ersten Feldeffekttransistors
- 132-3: Steueranschluss des ersten Feldeffekttransistors
- 133: Zweiter Feldeffekttransistor
- 133-1: Erster Signalanschluss des zweiten Feldeffekttransistors
- 133-2: Zweiter Signalanschluss des zweiten Feldeffekttransistors
- 133-3: Steueranschluss des zweiten Feldeffekttransistors
- 134, ..., 139: ohmsche Widerstände
- 14: Erster Empfangspfad
- 140: Zweites Schaltungsmodul
- 141: Diode
- 141-1: Kathodenanschluss der Diode
- 141-2: Anodenanschluss der Diode
- 142: Erster Bipolartransistor
- 142-1: Erster Signalanschluss des ersten Bipolartransistors
- 142-2: Zweiter Signalanschluss des ersten Bipolartransistors
- 142-3: Steueranschluss des ersten Bipolartransistors
- 143: Zweiter Bipolartransistor
- 143-1: Erster Signalanschluss des zweiten Bipolartransistors
- 143-2: Zweiter Signalanschluss des zweiten Bipolartransistors
- 143-3: Steueranschluss des zweiten Bipolartransistors
- 144, ..., 148: ohmsche Widerstände

- 15: Zweiter Empfangspfad
- 150: Drittes Schaltungsmodul
- 151: Diode
- 151-1: Kathodenanschluss der Diode
- 151-2: Anodenanschluss der Diode
- 152: Erster Feldeffekttransistor
- 152-1: Erster Signalanschluss des ersten Feldeffekttransistors
- 152-2: Zweiter Signalanschluss des ersten Feldeffekttransistors
- 152-3: Steueranschluss des ersten Feldeffekttransistors
- 153: Zweiter Feldeffekttransistor
- 153-1: Erster Signalanschluss des zweiten Feldeffekttransistors
- 153-2: Zweiter Signalanschluss des zweiten Feldeffekttransistors
- 153-3: Steueranschluss des zweiten Feldeffekttransistors
- 154, ..., 158: ohmsche Widerstände

- 16a: Erster Versorgungskontakt
- 16b: Zweiter Versorgungskontakt
- 16b': Spannungswandlerausgang
- 17a: Erster Massekontakt
- 17b: Zweiter Massekontakt

- 18: Kommunikationssignalkontakt(e)
- 19: Gehäuse

- 3: Mehrspannungsbordnetz

- 31: Erstes Teilnetz
- 311: Erste Spannungsversorgungsquelle
- 312: Kommunikationskomponente des ersten Teilnetzes
- 316: Erster Masseanschluss

- 32: Zweites Teilnetz
- 321: Zweite Spannungsversorgungsquelle
- 322: Elektrischer Motor
- 323: Umrichteranordnung
- 326: Zweiter Masseanschluss

## Patentansprüche

1. Steuervorrichtung (1) für ein Mehrspannungsbordnetz (3) eines Fahrzeugs, wobei das Mehrspannungsbordnetz (3) ein erstes Teilnetz (31) aufweist, das ausgebildet ist, von einer ersten Spannungsversorgungsquelle (311) mit einer ersten Versorgungsspannung betrieben zu werden, und ein zweites Teilnetz (32), das ausgebildet ist, von einer zweiten Spannungsversorgungsquelle (321) mit einer zweiten Versorgungsspannung betrieben zu werden; die Steuervorrichtung (1) umfassend:
- einen Sendeempfänger (11), der über einen ersten Masseanschluss (316) des ersten Teilnetzes (31) auf Masse geschaltet ist, und der ausgebildet ist zum Kommunizieren mit einer Kommunikationskomponente (312) des ersten Teilnetzes (31);
- eine Steuereinheit (12), die über einen zweiten Masseanschluss (326) des zweiten Teilnetzes (32) auf dieselbe Masse geschaltet ist, und die ausgebildet ist zum Steuern einer Leistungskomponente (322, 323) des zweiten Teilnetzes (32);
- einen Sendepfad (13), der einen Signalausgang (12-1) der Steuereinheit (12) an einen Signaleingang (11-1) des Sendeempfängers (11) koppelt, wobei der Sendepfad (13) ausgebildet ist zum Übertragen eines von der Steuereinheit (12) am Signalausgang (12-1) bereitgestellten Steuersignals hin zum Signaleingang (11-1) des Sendeempfängers (11);
- eine im Sendepfad (13) angeordnete Diode (131), deren Kathodenanschluss (131-1) an den zweiten Masseanschluss (326) gekoppelt ist;
und
- eine Anzahl von wenigstens zwei Feldeffekttransistoren (132, 133), wobei die Anzahl von Feldeffekttransistoren (132, 133) einen ersten, im Sendepfad (13) angeordneten Feldeffekttransistor (132) umfasst, der einen an die erste Spannungsversorgungsquelle (311) gekoppelten ersten Signalanschluss (132-1) und einen an den Signaleingang (11-1) des Sendeempfängers (11) gekoppelten zweiten Signalanschluss (132-2) aufweist, und die Anzahl von Feldeffekttransistoren (132, 133) einen zweiten, im Sendepfad (13) angeordneten Feldeffekttransistor (133) umfasst, der aufweist:
- einen an den Kathodenanschluss (131-1) der Diode (131) gekoppelten ersten Signalanschluss (133-1);
- einen an den zweiten Masseanschluss (326) gekoppelten zweiten Signalanschluss (133-2);
- einen an den Signalausgang (12-1) der Steuereinheit (12) gekoppelten Steueranschluss (133-3), wobei ein Anodenanschluss (131-2) der Diode (131) an einen Steueranschluss (132-3) des ersten Feldeffekttransistors (132) gekoppelt ist, und wobei die zweite Versorgungsspannung größer ist als die erste Versorgungsspannung.

2. Steuervorrichtung (1) nach Anspruch 1, **dadurch gekennzeichnet, dass** der erste Signalanschluss (132-1) des ersten Feldeffektransistors (132) über einen ohmschen Widerstand (137) an den Steueranschluss (132-3) des ersten Feldeffekttransistors (132) gekoppelt ist.

3. Steuervorrichtung (1) nach Anspruch 1 oder 2, **dadurch gekennzeichnet, dass** der Steueranschluss (132-3) des ersten Feldeffekttransistors (132) über die Diode (131) an den ersten Signalanschluss (133-1) des zweiten Feldeffekttransistors (133) gekoppelt ist.

4. Steuervorrichtung (1) nach Anspruch 1, **dadurch gekennzeichnet, dass** der zweite Signalanschluss (132-2) des ersten Feldeffekttransistors (132) über einen weiteren ohmschen Widerstand (139) an den ersten Masseanschluss (316) gekoppelt ist.

5. Steuervorrichtung (1) für ein Mehrspannungsbordnetz (3) eines Fahrzeugs, wobei das Mehrspannungsbordnetz (3) ein erstes Teilnetz (31) aufweist, das ausgebildet ist, von einer ersten Spannungsversorgungsquelle (311) mit einer ersten Versorgungsspannung betrieben zu werden, und ein zweites Teilnetz (32), das ausgebildet ist, von einer zweiten Spannungsversorgungsquelle (321) mit einer zweiten Versorgungsspannung betrieben zu werden; die Steuervorrichtung (1) umfassend:
- einen Sendeempfänger (11), der über einen ersten Masseanschluss (316) des ersten Teilnetzes (31) auf Masse geschaltet ist, und der ausgebildet ist zum Kommunizieren mit einer Kommunikationskomponente (312) des ersten Teilnetzes (31);
- eine Steuereinheit (12), die über einen zweiten Masseanschluss (326) des zweiten Teilnetzes (32) auf dieselbe Masse geschaltet ist, und die ausgebildet ist zum Steuern einer Leistungskomponente (322, 323) des zweiten Teilnetzes (32);
- einen Empfangspfad (14;15), der einen Signalausgang (11-2; 11-3) des Sendeempfängers (11) an einen Signaleingang (12-2; 12-3) der Steuereinheit (12) koppelt, wobei der Empfangspfad (14; 15) ausgebildet ist zum Übertragen eines von dem Sendeempfänger (11) am Signalausgang (11-2; 11-3) bereitgestellten Steuersignals hin zum Signaleingang (12-2; 12-3) der Steuereinheit (12);
- eine im Empfangspfad (14; 15) angeordnete Diode (141; 151), deren Kathodenanschluss (141-1; 151-1) an den zweiten Masseanschluss (326) gekoppelt ist;
und
- eine Anzahl von wenigstens zwei Transistoren (142, 143; 152, 153), wobei die Anzahl von Transistoren (142, 143; 152, 153) einen ersten, im Empfangspfad (14; 15) angeordneten Transistor (142; 152) umfasst, der einen an die erste Spannungsversorgungsquelle (311) gekoppelten ersten Signalanschluss (142-1; 152-1) und einen an den Signalausgang (11-2; 11-3) des Sendeempfängers (11) gekoppelten Steueranschluss (142-3; 152-3) aufweist, und die Anzahl von Transistoren (142, 143; 152, 153) einen zweiten, im Empfangspfad (14; 15) angeordneten Transistor (143; 153) umfasst, der aufweist:
- einen an den Kathodenanschluss (141-1; 151-1) der Diode (141; 151) gekoppelten Steueranschluss (143-3; 153-3);
- einen an den Signaleingang (12-2; 12-3) der Steuereinheit (12) gekoppelten ersten Signalanschluss (143-1; 153-1);
- einen an den zweiten Masseanschluss (326) gekoppelten zweiten Signalanschluss (143-2; 153-2), **wobei** ein Anodenanschluss (141-2; 151-2) der Diode (141; 151) an einen zweiten Signalanschluss (142-2; 152-2) des ersten Transistors (142; 152) gekoppelt ist, und wobei die zweite Versorgungsspannung größer ist als die erste Versorgungsspannung.

6. Steuervorrichtung (1) nach Anspruch 5, **dadurch gekennzeichnet, dass** der erste Signalanschluss (142-1; 152-1) des ersten Transistors (142; 152) über einen ohmschen Widerstand (145; 155) an den Steueranschluss (142-3; 152-3) des ersten Transistors (142; 152) gekoppelt ist.

7. Steuervorrichtung (1) nach Anspruch 5, **dadurch gekennzeichnet, dass** der zweite Signalanschluss (142-2; 152-2) des ersten Transistors (142; 152) über die Diode (141; 151) an den Steueranschluss (143-3; 153-3) des zweiten Transistors (143; 153) gekoppelt ist.

8. Steuervorrichtung (1) nach Anspruch 5, **dadurch gekennzeichnet, dass** der Steueranschluss (143-3; 153-3) des zweiten Transistors (143; 153) über einen weiteren ohmschen Widerstand (147; 157) an den zweiten Masseanschluss (326) gekoppelt ist.

9. Steuervorrichtung (1) nach einem der Ansprüche 5 bis 8, **dadurch gekennzeichnet, dass** der Signaleingang (12-2; 12-3) der Steuereinheit (12) über einen noch weiteren ohmschen Widerstand (148; 158) an die zweite Spannungsversorgungsquelle (321) gekoppelt ist.

## Claims

1. Control device (1) for a multi-voltage on-board electrical system (3) of a vehicle, wherein the multi-voltage on-board electrical system (3) comprises a first subsystem (31) configured to be operated with a first supply voltage from a first voltage supply source (311), and a second subsystem (32) configured to be operated with a second supply voltage from a second voltage supply source (321); the control device (1) comprising:
- a transceiver (11), which is connected to earth via a first earth terminal (316) of the first subsystem (31) and which is configured for communicating with a communication component (312) of the first subsystem (31);
- a control unit (12), which is connected to the same earth via a second earth terminal (326) of the second subsystem (32) and which is configured for controlling a power component (322, 323) of the second subsystem (32);
- a transmission path (13), which couples a signal output (12-1) of the control unit (12) to a signal input (11-1) of the transceiver (11), wherein the transmission path (13) is configured for transmitting a control signal provided by the control unit (12) at the signal output (12-1) towards the signal input (11-1) of the transceiver (11);
- a diode (131) arranged in the transmission path (13), the cathode terminal (131-1) of said diode being coupled to the second earth terminal (326); and
- a number of at least two field effect transistors (132, 133), wherein the number of field effect transistors (132, 133) comprises a first field effect transistor (132) arranged in the transmission path (13), said first field effect transistor having a first signal terminal (132-1) coupled to the first voltage supply source (311) and a second signal terminal (132-2) coupled to the signal input (11-1) of the transceiver (11), and the number of field effect transistors (132, 133) has a second field effect transistor (133) arranged in the transmission path (13), said second field effect transistor having:
- a first signal terminal (133-1) coupled to the cathode terminal (131-1) of the diode (131);
- a second signal terminal (133-2) coupled to the second earth terminal (326);
- a control terminal (133-3) coupled to the signal output (12-1) of the control unit (12), wherein an anode terminal (131-2) of the diode (131) is coupled to a control terminal (132-3) of the first field effect transistor (132), and wherein the second supply voltage is greater than the first supply voltage.

2. Control device (1) according to Claim 1, **characterized in that** the first signal terminal (132-1) of the first field effect transistor (132) is coupled to the control terminal (132-3) of the first field effect transistor (132) via an ohmic resistor (137).

3. Control device (1) according to Claim 1 or 2, **characterized in that** the control terminal (132-3) of the first field effect transistor (132) is coupled to the first signal terminal (133-1) of the second field effect transistor (133) via the diode (131) .

4. Control device (1) according to Claim 1, **characterized in that** the second signal terminal (132-2) of the first field effect transistor (132) is coupled to the first earth terminal (316) via a further ohmic resistor (139).

5. Control device (1) for a multi-voltage on-board electrical system (3) of a vehicle, wherein the multi-voltage on-board electrical system (3) comprises a first subsystem (31) configured to be operated with a first supply voltage from a first voltage supply source (311), and a second subsystem (32) configured to be operated with a second supply voltage from a second voltage supply source (321); the control device (1) comprising:
- a transceiver (11), which is connected to earth via a first earth terminal (316) of the first subsystem (31) and which is configured for communicating with a communication component (312) of the first subsystem (31);
- a control unit (12), which is connected to the same earth via a second earth terminal (326) of the second subsystem (32) and which is configured for controlling a power component (322, 323) of the second subsystem (32);
- a reception path (14; 15), which couples a signal output (11-2; 11-3) of the transceiver (11) to a signal input (12-2; 12-3) of the control unit (12), wherein the reception path (14; 15) is configured for transmitting a control signal provided by the transceiver (11) at the signal output (11-2; 11-3) towards the signal input (12-2; 12-3) of the control unit (12);
- a diode (141; 151) arranged in the reception path (14; 15), the cathode terminal (141-1; 151-1) of said diode being coupled to the second earth terminal (326); and
- a number of at least two transistors (142, 143; 152, 153), wherein the number of transistors (142, 143; 152, 153) comprises a first transistor (142; 152) arranged in the reception path (14; 15), said first transistor having a first signal terminal (142-1; 152-1) coupled to the first voltage supply source (311) and a control terminal (142-3; 152-3) coupled to the signal output (11-2; 11-3) of the transceiver (11), and the number of transistors (142, 143; 152, 153) comprises a second transistor (143; 153) arranged in the reception path (14; 15), said second transistor having:
- a control terminal (143-3; 153-3) coupled to the cathode terminal (141-1; 151-1) of the diode (141; 151);
- a first signal terminal (143-1; 153-1) coupled to the signal input (12-2; 12-3) of the control unit (12);
- a second signal terminal (143-2; 153-2) coupled to the second earth terminal (326), **wherein** an anode terminal (141-2; 151-2) of the diode (141; 151) is coupled to a second signal terminal (142-2; 152-2) of the first transistor (142; 152), and wherein the second supply voltage is greater than the first supply voltage.

6. Control device (1) according to Claim 5, **characterized in that** the first signal terminal (142-1; 152-1) of the first transistor (142; 152) is coupled to the control terminal (142-3; 152-3) of the first transistor (142; 152) via an ohmic resistor (145; 155).

7. Control device (1) according to Claim 5, **characterized in that** the second signal terminal (142-2; 152-2) of the first transistor (142; 152) is coupled to the control terminal (143-3; 153-3) of the second transistor (143; 153) via the diode (141; 151).

8. Control device (1) according to Claim 5, **characterized in that** the control terminal (143-3; 153-3) of the second transistor (143; 153) is coupled to the second earth terminal (326) via a further ohmic resistor (147; 157).

9. Control device (1) according to any of Claims 5 to 8, **characterized in that** the signal input (12-2; 12-3) of the control unit (12) is coupled to the second voltage supply source (321) via yet another ohmic resistor (148; 158).

## Revendications

1. Dispositif de commande (1) destiné à un réseau de bord multi-tension (3) d'un véhicule, le réseau de bord multi-tension (3) comportant un premier sous-réseau (31) qui est conçu pour être utilisé par une première source d'alimentation en tension (311) ayant une première tension d'alimentation, et un deuxième sous-réseau (32) qui est conçu pour être utilisé par une deuxième source d'alimentation en tension (321) ayant une deuxième tension d'alimentation ; le dispositif de commande (1) comprenant :
- un émetteur-récepteur (11) qui est relié à la masse par le biais d'une première borne de masse (316) du premier sous-réseau (31) et qui est conçu pour communiquer avec un composant de communication (312) du premier sous-réseau (31) ;
- une unité de commande (12) qui est reliée à la même masse par le biais d'une deuxième borne de masse (326) du deuxième sous-réseau (32) et qui est conçue pour commander un composant de puissance (322, 323) du deuxième sous-réseau (32) ;
- un chemin d'émission (13) qui couple une sortie de signal (12-1) de l'unité de commande (12) à une entrée de signal (11-1) de l'émetteur-récepteur (11), le chemin d'émission (13) étant conçu pour transmettre un signal de commande, fourni par l'unité de commande (12) à la sortie de signal (12-1), à l'entrée de signal (11-1) de l'émetteur-récepteur (11) ;
- une diode (131) qui est disposée dans le chemin d'émission (13) et dont la borne cathodique (131-1) est couplée à la deuxième borne de masse (326) ;
et
- un nombre d'au moins deux transistors à effet de champ (132, 133), le nombre de transistors à effet de champ (132, 133) comprenant un premier transistor à effet de champ (132) qui est disposé dans le chemin d'émission (13) et qui comporte une première borne de signal (132-1) couplée à la première source d'alimentation en tension (311) et une deuxième borne de signal (132-2) couplée à l'entrée de signal (11-1) de l'émetteur-récepteur (11), et le nombre de transistors à effet de champ (132, 133) comportant un deuxième transistor à effet de champ (133) qui est disposé dans le chemin d'émission (13) et qui comprend :
- une première borne de signal (133-1) couplée à la borne cathodique (131-1) de la diode (131) ;
- une deuxième borne de signal (133-2) couplée à la deuxième borne de masse (326) ;
- une borne de commande (133-3) couplée à la sortie de signal (12-1) de l'unité de commande (12), une borne anodique (131-2) de la diode (131) étant couplée à une borne de commande (132-3) du premier transistor à effet de champ (132) et la deuxième tension d'alimentation étant supérieure à la première tension d'alimentation.

2. Dispositif de commande (1) selon la revendication 1, **caractérisé en ce que** la première borne de signal (132-1) du premier transistor à effet de champ (132) est couplée à la borne de commande (132-3) du premier transistor à effet de champ (132) par le biais d'une résistance ohmique (137).

3. Dispositif de commande (1) selon la revendication 1 ou 2, **caractérisé en ce que** la borne de commande (132-3) du premier transistor à effet de champ (132) est couplée à la première borne de signal (133-1) du deuxième transistor à effet de champ (133) par le biais de la diode (131).

4. Dispositif de commande (1) selon la revendication 1, **caractérisé en ce que** la deuxième borne de signal (132-2) du premier transistor à effet de champ (132) est couplée à la première borne de masse (316) par le biais d'une autre résistance ohmique (139).

5. Dispositif de commande (1) destiné à un réseau de bord multi-tension (3) d'un véhicule, le réseau de bord multi-tension (3) comportant un premier sous-réseau (31) qui est conçu pour être utilisé par une première source d'alimentation en tension (311) ayant une première tension d'alimentation, et un deuxième sous-réseau (32) qui est conçu pour être utilisé par une deuxième source d'alimentation en tension (321) ayant une deuxième tension d'alimentation ; le dispositif de commande (1) comprenant :
- un émetteur-récepteur (11) qui est relié à la masse par le biais d'une première borne de masse (316) du premier sous-réseau (31) et qui est conçu pour communiquer avec un composant de communication (312) du premier sous-réseau (31) ;
- une unité de commande (12) qui est reliée à la même masse par le biais d'une deuxième borne de masse (326) du deuxième sous-réseau (32) et qui est conçue pour commander un composant de puissance (322, 323) du deuxième sous- réseau (32) ;
- un chemin de réception (14 ; 15) qui couple une sortie de signal (11-2 ; 11-3) de l'émetteur-récepteur (11) à une entrée de signal (12-2 ; 12-3) de l'unité de commande (12), le chemin de réception (14 ; 15) étant conçu pour transmettre un signal de commande, fourni par l'émetteur-récepteur (11) à la sortie de signal (11-2 ; 11-3), à l'entrée de signal (12-2 ; 12-3) de l'unité de commande (12) ;
- une diode (141 ; 151) qui est disposée dans le chemin de réception (14 ; 15) et dont la borne cathodique (141-1 ; 151-1) est couplée à la deuxième borne de masse (326),
et
- un nombre d'au moins deux transistors (142, 143 ; 152, 153), le nombre de transistors (142, 143 ; 152, 153) comprenant un premier transistor (142 ; 152) qui est disposé dans le chemin de réception (14 ; 15) et qui comporte une première borne de signal (142-1 ; 152-1), couplée à la première source d'alimentation en tension (311), et une borne de commande (142-3 ; 152-3) couplée à la sortie de signal (11-2 ; 11-3) de l'émetteur-récepteur (11), et le nombre de transistors (142, 143 ; 152, 153) comprenant un deuxième transistor (143 ; 153) qui est disposé dans le chemin de réception (14 ; 15) et qui comporte :
- une borne de commande (143-3 ; 153-3) couplée à la borne cathodique (141-1 ; 151-1) de la diode (141 ; 151) ;
- une première borne de signal (143-1 ; 153-1) couplée à l'entrée de signal (12-2 ; 12-3) de l'unité de commande (12) ;
- une deuxième borne de signal (143-2 ; 153-2) couplée à la deuxième borne de masse (326), une borne anodique (141-2 ; 151-2) de la diode (141 ; 151) étant couplée à une deuxième borne de signal (142-2 ; 152-2) du premier transistor (142 ; 152) et la deuxième tension d'alimentation étant supérieure à la première tension d'alimentation.

6. Dispositif de commande (1) selon la revendication 5, **caractérisé en ce que** la première borne de signal (142-1 ; 152-1) du premier transistor (142 ; 152) est couplée à la borne de commande (142-3 ; 152-3) du premier transistor (142 ; 152) par le biais d'une résistance ohmique (145 ; 155).

7. Dispositif de commande (1) selon la revendication 5, **caractérisé en ce que** la deuxième borne de signal (142-2 ; 152-2) du premier transistor (142 ; 152) est couplée à la borne de commande (143-3 ; 153-3) du deuxième transistor (143 ; 153) par le biais de la diode (141 ; 151).

8. Dispositif de commande (1) selon la revendication 5, **caractérisé en ce que** la borne de commande (143-3 ; 153-3) du deuxième transistor (143 ; 153) est couplée à la deuxième borne de masse (326) par le biais d'une autre résistance ohmique (147 ; 157).

9. Dispositif de commande (1) selon l'une des revendications 5 à 8, **caractérisé en ce que** le signal d'entrée (12-2 ; 12-3) de l'unité de commande (12) est couplé à la deuxième source d'alimentation en tension (321) par le biais d'encore une autre résistance ohmique (148 ; 158).
